Europäisches Patentamt

(19) European Patent Office

Office européen des brevets

(11) Numéro de publication: **0 252 794**
**B1**

(12) **FASCICULE DE BREVET EUROPEEN**

(45) Date de publication du fascicule du brevet:
**11.04.90**

(51) Int. Cl.⁴: **G11C 17/00, G11C 5/00**

(21) Numéro de dépôt: **87401397.2**

(22) Date de dépôt: **19.06.87**

(54) Dispositif de détection du fonctionnement du système de lecture d'une cellule-mémoire EPROM ou EEPROM.

(30) Priorité: **24.06.86 FR 8609103**

(43) Date de publication de la demande:
**13.01.88 Bulletin 88/2**

(45) Mention de la délivrance du brevet:
**11.04.90 Bulletin 90/15**

(84) Etats contractants désignés:
**CH DE ES FR GB IT LI NL**

(56) Documents cités:
**PATENT ABSTRACTS OF JAPAN,
vol. 7, no. 164 (P-211)[1309], 19 juillet 1983; &
JP-A-58 70 486 (NIPPON DENKI K.K.) 26-04-1983
PATENT ABSTRACTS OF JAPAN,
vol. 6, no. 38 (P-105)[916], 9 mars 1982; &
JP-A-56 156 992 (MATSUSHITA DENKI SANGYO
K.K.) 03-12-1981
PATENT ABSTRACTS OF JAPAN,
vol. 6, no. 221 (P-153)[1099], 5 nobembre 1982; &
JP-A-57 123 594 (MATSUSHITA DENKI SANGYO
K.K.) 02-08-1982
PATENT ABSTRACTS OF JAPAN,
vol. 7, no. 196 (P-219)[1341], 26 août 1983; &
JP-A-58 94 195 (SHIN NIPPON DENKI K.K.) 04-06-1983
PATENT ABSTRACTS OF JAPAN,
vol. 1, no. 32 (E-76)[1401], 29 mars 1977; &**

(73) Titulaire: **THOMSON COMPOSANTS MILITAIRES ET
SPATIAUX, 173, Bd Haussmann, F-75008 Paris(FR)**

(72) Inventeur: **Gaudronneau, Yann, Thomson-CSF
SCPI 19 Avenue de Messine, F-75008 Paris(FR)**

(74) Mandataire: **Ruellan-Lemonnier, Brigitte et al,
THOMSON-CSF SCPI, F-92045 PARIS LA DEFENSE
CEDEX 67(FR)**

(56) Documents cités: (suite)

**JP-A-51 126 732 (HITACHI SEISAKUSHO
K.K.) 05-11-1976**

## Description

La présente invention concerne un dispositif de détection du fonctionnement du système de lecture d'une cellule-mémoire EPROM ou EEPROM.

Certains circuits intégrés actuellement disponibles sur le marché sont réalisées avec une mémoire non volatile programmable électriquement dans laquelle sont enregistrées le plus souvent des donnés non modifiables.Or, les mémoires non volatiles programmables électriquement utilisées dans ces circuits intégrés sont en général constituées par des mémoires du type EPROM ou EEPROM.

Dans les mémoires du type ci-dessus, chaque élément de stockage d'information ou cellule-mémoire est constitué par un transistor MOS à grille flottante qui peut être principalement de type FAMOS (pour Floating Gate Avalanche Injection MOS) ou de type SAMOS (pour Stacked Gate Avalanche Injection MOS). Le transistor MOS ci-dessus peut avoir deux états. Pour un transistor MOS à canal N, dans un premier état aucune charge n'est piégée sur la grille flottante.Un canal de conduction peut exister entre source et drain. Le transistor conduit alors et se comporte comme un interrupteur fermé. Dans un deuxième état, des électrons ont été piégés sur la grille flottante. Ils empêchent la création d'un canal de conduction dans le substrat entre source et drain. Dans ce cas, le transistor est bloqué et se comporte comme un interrupteur ouvert.

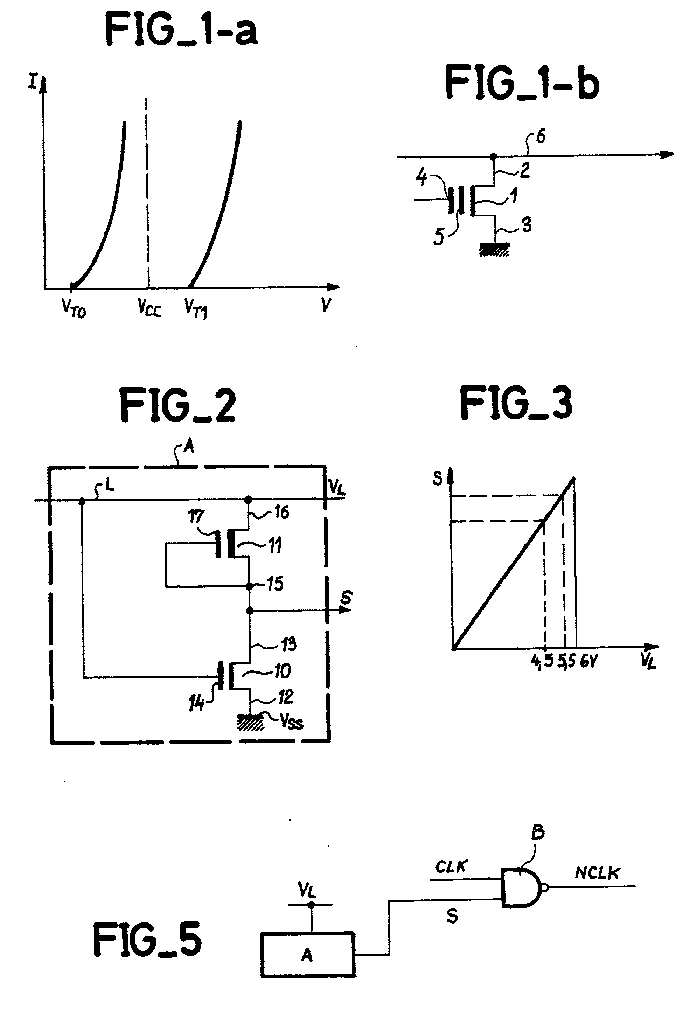

Pour programmer un transistor MOS 1 du type de celui représenté sur la figure 1B, des tensions plus élevées que la tension de fonctionnement normale sont convenablement appliquées sur la grille de commande 4 et l'électrode 2 de sorte que la grille flottante 5 absorbe et garde une charge d'électrons. Cette charge d'électrons sur la grille flottante 5 augmente le seuil de conduction sur la grille de commande 4 du transistor, de la tension de seuil minimale $V_{T0}$ des transistors non programmés à une tension de seuil supérieure $V_{T1}$, comme représenté sur la figure 1A qui donne le diagramme de la caractéristique de fonctionnement d'un transistor à grille flottante de type SAMOS.

Pour lire une mémoire ainsi programmée, une tension Vcc, inférieure à la tension de seuil $V_{T1}$ des transistors programmés, mais supérieure à la tension minimale $V_{T0}$ des transistors non programmés, doit être appliquée sur la grille de commande. Cette tension de lecture permet de détecter l'état passant ou bloqué du transistor. Comme représenté sur la figure 1B, de manière générale, le transistor 1 est relié par l'électrode 2 à une ligne de bit 6 polarisée en tension par un générateur. L'autre électrode 3 du transistor est reliée à la masse. La ligne de bit 6 est également reliée à un senseur de courant non représenté. Ce senseur mesure le courant débité dans la ligne par le générateur. Si la cellule-mémoire n'a pas été programmée, le transistor est passant, et lors de l'application de la tension de lecture Vcc qui est supérieure à $V_{T0}$, le transistor est mis en saturation. On détecte sur le senseur une chute de courant. Dans le deuxième cas, lorsque la cellule-mémoire a été programmée, les charges sont piégées sur la grille flottante du transistor. La tension de lecture Vcc appliquée sur la grille de commande est, dans ce cas, de sens opposé à la barrière de potentiel créée dans le canal de conduction par les charges stockées dans la grille flottante. Mais elle est alors insuffisante pour modifier la conduction du canal et le transistor reste bloqué. En conséquence, le senseur en bout de la ligne de bit ne perçoit pas de variation de courant.

Si avec les mémoires ci-dessus l'on utilise pour la tension de lecture Vcc une tension supérieure à la tension de seuil $V_{T1}$, quel que soit l'état programmé ou non programmé des cellules-mémoire, on détecte sur les senseurs une chute de courant. En conséquence, on lit l'ensemble des cellules-mémoire comme si elles n'étaient pas programmées. Il est donc possible de lire des cellules programmées comme étant non programmées. Pour remédier à cet inconvénient, il faudrait que les circuits avec EPROM ou EEPROM ne fonctionnent pas pour des tensions de lecture supérieures à la tension de seuil $V_{T1}$. Or, avec les circuits actuellement disponibles, il est possible d'appliquer une tension de lecture Vcc supérieure à la tension de seuil $V_{T1}$ sans pour autant modifier le fonctionnement du circuit.

La présente invention a pour but de remédier à ces inconvénients en proposant un dispositif qui permet le fonctionnement du circuit pour une tension de lecture comprise entre $V_{T0}$ et $V_{T1}$ et qui modifie le fonctionnement du circuit pour une tension légèrement supérieure à cette tension de lecture, mais inférieure à la tension de seuil $V_{T1}$ des cellules-mémoire programmées.

En conséquence, la présente invention telle que revendiqué dans la revendication 1 a pour objet un dispositif de détection du fonctionnement de la lecture pour circuit intégré du type circuit logique comportant une mémoire non volatile contenant des données, la mémoire étant constituée par une matrice de cellules-mémoire du type à transistors MOS présentant suivant leur programmation à "0" ou à "1", des tensions de seuil $V_{T0}$ et $V_{T1}$ définies, lesdites cellules-mémoire étant lues en appliquant une tension de lecture $V_L$ telle que, en fonctionnement normal, $V_{T0} < V_L < V_{T1}$, caractérisé en ce que ce dispositif de détection est constitué par un inverseur comportant un transistor signal du type MOS enrichi présentant une tension de seuil $V_T$ telle que $V_L < V_T < V_{T1}$ dont la grille est con à une ligne sur laquelle est appliquée la tension de lecture et une charge connectée à la même ligne que la grille, l'inverseur délivrant un signal logique qui sert à signaler au circuit intégré que la tension de lecture appliquée est supérieure à la tension de seuil $V_T$.

Selon un mode de réalisation préférentiel, la charge est constituée par un transistor MOS déplété dont la grille est connectée à la source.

D'autre part, pour obtenir un signal logique franc, la largeur W du transistor signal est grande par rapport à sa longueur de manière à être insensible aux variations du rapport W/L ou de la résistance du transistor de charge. Ainsi, la largeur du transistor signal est comprise entre 50 et 100 microns, de préférence 100 microns, pour une longueur de 4 à 6 µ, en technologie NMOS.

Selon une autre caractéristique de la présente invention, le signal logique en sortie de l'inverseur est envoyé sur une porte qui reçoit sur une autre entrée un signal nécessaire au fonctionnement du circuit intégré tel que le signal horloge de manière à bloquer ou à modifier le fonctionnement dudit circuit lorsque la tension de lecture appliquée est supérieure à la tension de seuil $V_T$.

Les caractéristiques et avantages de la présente invention apparaîtront à la lecture de la description d'un mode de réalisation faite ci-après avec référence aux dessins ci-annexés dans lesquels:

- les figures 1A et 1B déjà décrites représentent respectivement la caractéristique tension-courant d'une cellule-mémoire avec transistor à grille flottante et ladite cellule-mémoire,
- la figure 2 représente le schéma d'un dispositif de détection conforme à la présente invention,
- la figure 3 représente la courbe de transfert du circuit de la figure 2,
- la figure 4 représente une vue de dessus de l'implantation logique du circuit de la figure 2, et
- la figure 5 représente une vue schématique d'un circuit permettant de détecter le fonctionnement du circuit utilisant le circuit de la figure 2.

La présente invention sera décrite en se référant à des transistors MOS à canal N comme les transistors de la mémoire non volatile électriquement programmable, car ceci correspond à la technologie la plus couramment utilisée. Il est évident pour l'homme de l'art que cette invention peut être facilement transposée à des transistors MOS à canal P.

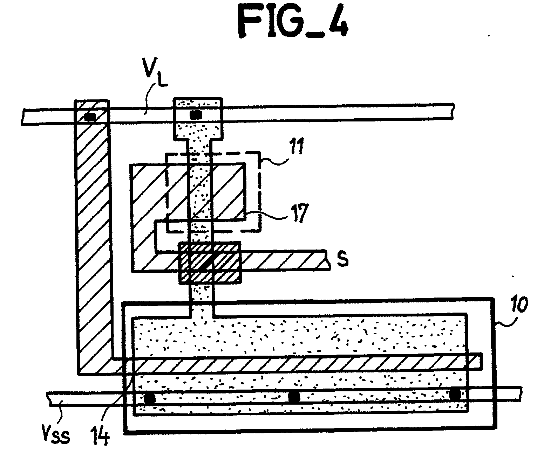

Comme représenté sur les figures 2 et 4, le dispositif de détection conforme à la présente invention est constitué essentiellement d'un transistor MOS 10 enrichi dont une des électrodes 12 est connectée à la masse Vss et dont l'autre électrode 13 est connectée à une charge déorite ultérieurement. La grille 14 de ce transistor MOS est connectée à la ligne L qui reçoit le signal d'entrée qui, dans le présent cas, est constitué par la tension de lecture $V_L$. Conformément à la présente invention, le transistor MOS enrichi 10 a été réalisé de manière à avoir une tension de seuil $V_T$ spécifique. Cette tension de seuil $V_T$ est comprise entre $V_L$ et $V_{T1}$, $V_{T1}$ correspondant à la tension de seuil des transistors MOS à grille flottante formant les cellules-mémoire programmées à "1" et $V_L$ correspondant à Vcc ou à une fraction de Vcc. A titre d'exemple, avec un $V_L$ pouvant varier entre 4,5 et 5,5 volts, la tension $V_T$ peut être choisie égale à 6 volts, $V_{T1}$ étant en général de l'ordre de 7 volts. L'utilisation d'un transistor MOS enrichi à tension de seuil spécifique permet de détecter de manière sûre le passage de la tension de lecture au-dessus de la tension de seuil. En effet, la tension de seuil $V_T$ est donnée avec une précision de + 0,3 volt dans les technologies habituellement utilisées, ce qui constitue un des avantages principaux de ce type de dispositif.

D'autre part, conformément au mode de réalisation préférentiel de la présente invention représenté sur les figures 2 et 4, la charge est constitué par un transistor MOS déplété 11. Ce transistor comporte une électrode 15 reliée à l'électrode 13 et son autre électrode 16 reliée à la tension $V_L$. De manière connue, la grille 17 est connectée à l'électrode 15 de telle sorte que la tension $V_{GS}$ = 0. La sortie S est prélevée en un point milieu entre les électrodes 13 et 15.

Avec le circuit représenté à la figure 2, tant que la tension $V_L$ est inférieure à $V_T$, le transistor 10 est bloqué et le transistor 11 fonctionne en régime triode. Dans la plage de fonctionnement normal du circuit, c'est-à-dire pour $V_L$ compris entre 4,5 volts et 5,5 volts, la sortie S délivre un signal logique "1". Pour une tension $V_L$ supérieure à $V_T$, le transistor 10 passe en régime triode, le transistor 11 en régime saturé et l'on obtient un signal de sortie S qui correspond à un niveau logique 0.

La courbe de transfert d'une tel circuit est du type de celle représentée sur la figure 3. Pour obtenir une pente raide au niveau du passage du "1" logique au "0" logique, il est important que le rapport W/L du transistor signal soit élevé. Ainsi, la largeur W du transistor 10 est comprise entre 50 et 100 microns tandis que sa longueur est comprise entre 4 et 6 microns. Avec ces caractéristiques, le transistor signal 10 est insensible aux variations du rapport W/L ou de la résistance du transistor 11. Ces caractéristiques sont représentées plus particulièrement sur la figure 4. D'autre part, sur la figure 4, les parties en pointillés représentent la diffusion, les parties hachurées représentent les grilles et leur interconnexion à des conducteurs, les points foncés représentent les contacts métal/diffusion ou métal/métal, la partie en tiretés représente l'implant de déplétion et la partie en traits épais représente l'implant spécial pour obtenir une tension de seuil d'environ 6 volts.

Par ailleurs, comme représenté à titre d'exemple sur la figure 5, le signal logique de sortie S du circuit de détection A conforme à la présente invention est envoyé sur une des entrées d'une porte ET B qui reçoit sur son autre entrée le signal d'horloge CLK. En sortie de la porte B, on obtient suivant le signal S un signal CLK ou une inhibition du signal CLK. En effet, si S est à "1", le signal CLK est transmis à travers la porte B, mais si S est à "0", le signal CLK n'est pas transmis, ce qui bloque en conséquence le fonctionnement du circuit. Il est évident pour l'homme de l'art que le dispositif de détection A pourrait être placé dans d'autres parties du circuit pourvu qu'il soit placé avant le fusible. D'autres signaux que le signal horloge jouant sur le fonctionnement du circuit peuvent être utilisés pour en modifier ou inhiber le fonctionnement.

Le circuit ci-dessus présente l'avantage d'être d'une conception très simple. Il ne nécessite qu'un seul niveau de masque supplémentaire. D'autre part, la tension $V_T$ est figée puisqu'elle est déterminée par le procédé de réalisation du transistor 10 lui-même.

Il est évident pour l'homme de l'art que la présente invention peut s'appliquer à toutes mémoires dont la lecture d'un point est réalisée de la même manière que dans les EPROM ou EEPROM.

**Revendications**

1. Un dispositif de détection du fonctionnement de la lecture pour circuit intégré du type circuit logique comportant une mémoire non volatile contenant des données, la mémoire étant constituée par une matrice de cellules-mémoire du type à transistors MOS présentant suivant leur programmation à "0" ou à "1", des tensions de seuil $V_{T0}$ et $V_{T1}$ définies, lesdites cellules-mémoire étant lues en appliquant une tension de lecture VL telle que, en fonctionnement normal $V_{T0} < VL < V_{T1}$, caractérisé en ce que ce dispositif de detéction (A) est constitué par un inverseur comportant

   – un transistor signal (10) du type MOS enrichi présentant une tension de seuil $V_T$ telle que $V_L < V_T < V_{T1}$ dont la grille (14) est connectée à la tension de lecture et

   – une charge (11) connectée à la tension de lecture, l'inverseur délivrant un signal logique S qui sert à signaler au circuit intégré que la tension de lecture appliquée est supérieure à la tension de seuil $V_T$.

2. Un dispositif de détection selon la revendication 1, caractérisé en ce que la charge est constituée par un transistor MOS déplété (11) dont la grille (17) est connectée à la source (15).

3. Un dispositif de détection selon la revendication 2, caractérisé en ce que la largeur W du canal du transistor enrichi (10) est très supérieure à sa longueur.

4. Un dispositif de détection selon la revendication 3, caractérisé en ce que la largeur W du canal du transistor enrichi (10) est comprise entre 50 et 100 microns, de préférence 100 microns pour une longueur comprise entre 4 et 6 microns.

5. Un dispositif de détection selon l'une quelconque des revendications 1 à 4, caractérisé en ce que le signal logique S en sortie de l'inverseur est envoyé sur une porte B qui reçoit sur son autre entrée un signal (CLK) nécessaire au fonctionnement du circuit intégré, de manière à signaler que la tension de lecture appliquée est supérieure à la tension de seuil $V_T$.

**Patentansprüche**

1. Einrichtung zur Erfassung des Lesebetriebs einer integrierten Schaltung vom Typ einer Logikschaltung mit einem datenenthaltenden Festspeicher, wobei der Speicher aus einer Matrix von MOS-Transistoren enthaltenden Speicherzellen besteht, die entsprechend ihrer Programmierung mit "0" oder "1" definierte Schwellenspannungen $V_{T0}$ und $V_{T1}$ aufweisen. und wobei die Speicherzellen durch Anlegen einer solchen Lesespannung VL gelesen wird, daß im Normalbetrieb $V_{T0} < VL < V_{T1}$ ist, dadurch gekennzeichnet, daß die Erfassungseinrichtung (A) aus einem Inverter besteht, der

   – einen Signaltransistor (10) vom Typ eines Anreicherungs-MOS, der eine Schwellenspannung $V_T$ solcher Art besitzt, daß $V_L < V_T < V_{T1}$ ist, und dessen Gitter (14) an die Lesespannung angeschlossen ist, und

   – eine Last (11) aufweist, die an die Lesespannung angeschlossen ist, wobei der Inverter ein logisches Signal S liefert, das der integrierten Schaltung anzeigt, daß die angelegte Lesespannung größer als die Schwellenspannung $V_T$ ist.

2. Erfassungseinrichtung nach Anspruch 1, dadurch gekennzeichnet, daß die Last aus einem Verarmungs-MOS-Transistor (11) besteht, dessen Gitter (17) an die Source (15) angeschlossen ist.

3. Erfassungseinrichtung nach Anspruch 2, dadurch gekennzeichnet, daß die Kanalbreite W des Anreicherungstransistors (10) erheblich größer als seine Länge ist.

4. Erfassungseinrichtung nach Anspruch 3, dadurch gekennzeichnet, daß die Kanalbreite W des Anreicherungstransistors (10) zwischen 50 und 100 µm, vorzugsweise 100 µm, beträgt, bei einer Kanallänge zwischen 4 und 6 µm.

5. Erfassungsvorrichtung nach einem beliebigen der Ansprüche 1 bis 4, dadurch gekennzeichnet, daß das am Ausgang des Inverters erscheinende logische Signal S an ein Tor B übermittelt wird, das an seinem anderen Eingang ein für den Betrieb der integrierten Schaltung benötigtes Signal (CLK) empfängt, derart, daß angezeigt wird, daß die angelegte Lesespannung größer als die Schwellenspannung $V_T$ ist.

**Claims**

1. A device for detecting the functionning of the read mode in integral circuits of the logic circuit type comprising a nonvolatile memory with the data contained therein, the memory being constituted by a matrix of MOS transistor memory-cells adapted to present defined threshold voltages $V_{T0}$ and $V_{T1}$ in accordance with their programming in terms of logic state "0" or "1", said memory-cells being read out by way of applying a reading voltage VL thereto, such that $V_{T0} < VL < V_{T1}$ in normal operation, characterized in that the detection device (A) is constituted by an inverter comprising:

   – an enhancement MOS-type signal transistor (10) having a threshold voltage $V_T$ such that $V_L < V_T < V_{T1}$, and whose gate (14) is connected to the reading voltage, and

   – a load (11) connected to the reading voltage, the inverter providing a logic signal S used to notify the integrated circuit that the reading voltage exceeds the threshold voltage $V_T$.

2. A detection device according to claim 1, characterized in that the load is constituted by a depletion MOS-type transistor (11), whose gate (17) is connected to the source (15).

3. A detection device according to claim 2, characterized in that the width W of the channel of the enhancement transistor (10) exceeds its length considerably.

4. A detection device according to claim 3, characterized in that the width W of the channel of the enhancement transistor (10) is comprised between 50 and 100 μm, preferably 100 μm with the channel length being comprised between 4 and 6 μm.

5. A detection device according to anyone of the claims 1 to 4, characterized in that the logic signal S at the output of the inverter is conveyed to a gate B, which receives on its outer input a signal (CLK) required to operate the integrated circuit, so as to notify the fact that the applied reading voltage exceeds the threshold voltage $V_T$.

# FIG_1-a

# FIG_1-b

# FIG_2

# FIG_3

# FIG_5

# FIG_4